# FASCICULE DE BREVET EUROPEEN

(11) **EP 1 797 748 B1**
(45) Date de publication et mention de la délivrance du brevet: **17.05.2017**
(21) Numéro de dépôt: 05802576.8
(22) Date de dépôt: 29.09.2005
(51) Int. Cl.: H05K 3/34

(54) **COMPOSANT A PROTUBERANCES CONDUCTRICES DUCTILES ENTERREES ET PROCEDE DE CONNEXION ELECTRIQUE ENTRE CE COMPOSANT ET UN COMPOSANT MUNI DE POINTES CONDUCTRICES DURES**
KOMPONENTE MIT EINGELASSENEN LEITFÄHIGEN BUMPS UND VERFAHREN ZUR ELEKTRISCHEN VERBINDUNG ZWISCHEN BESAGTER KOMPONENTE UND EINE MIT HARTEN LEITFÄHIGEN SPITZEN BESTÜCKTE KOMPONENTE
COMPONENT WITH BURIED DUCTILE CONDUCTIVE BUMPS AND METHOD FOR ELECTRIC CONNECTION BETWEEN SAID COMPONENT AND A COMPONENT PROVIDED WITH HARD CONDUCTIVE TIPS

(30) Priorité: 04.10.2004 FR 0452249
(43) Date de publication de la demande: 20.06.2007
(73) Titulaire: Commissariat à l'Énergie Atomique et aux Énergies Alternatives, 75015 Paris (FR)
(72) Inventeur: DAVOINE, Cécile, F-76620 LE HAVRE (FR); FENDLER, Manuel, F-38000 GRENOBLE (FR)
(74) Mandataire: Ahner, Philippe
(86) Numéro de dépôt international: PCT/FR2005/050795
(87) Numéro de publication internationale: WO 2006/054005

(56) Documents cités:
- WO-A-2004/093266
- US-A1- 2002 153 608
- US-A1- 2003 234 277

## Description

### DOMAINE TECHNIQUE

La présente invention concerne un composant à protubérances conductrices ductiles enterrées et un procédé de connexion électrique entre ce composant et un composant muni de pointes conductrices dures.

### ÉTAT DE LA TECHNIQUE ANTÉRIEURE

Dans le domaine de la connectique utilisant la technique « flip chip », la tendance actuelle est à la réduction du « pas », c'est-à-dire de la distance entre les interconnexions reliant puce et substrat. Dans une telle technique un substrat a tous les contacts, sous forme de protubérances ou de protubérances (« bump ») métalliques, situés sur une seule face. La puce est retournée de telle sorte que les protubérances puissent être soudées à des conducteurs appropriés sur cette puce. Cependant les méthodes d'hybridation conventionnelles telles que la brasure de protubérances ou la thermo-compression de plots, ainsi que des méthodes plus récentes telles que les ACF (« Anisotropic Conductive Films ») ou l'utilisation de polymères conducteurs montrent leurs limites en termes de réduction du pas.

La réalisation de connexions électriques par insertion de micro-pointes ou « pointes » conductrices dures dans des protubérances conductrices ductiles apparaît être une solution compatible avec une telle réduction du pas dans la mesure où elle est « sans-flux », nécessite une faible pression mécanique et permet de rattraper les flèches éventuelles de la puce ou du substrat.

Le document référencé [1] en fin de description décrit, ainsi, un procédé de connexion par insertion d'une première pièce munie de plusieurs pointes avec une seconde pièce munie de plots surmontés de protubérances de soudure sans utiliser de flux. Ce procédé comprend les étapes consistant à aspirer sous vide la première pièce, presser au moins une pointe de la première pièce contre un plot de la seconde pièce, percer à l'aide de cette pointe la croûte d'oxyde natif en surface de la protubérance de soudure en chauffant au dessus de la température de fusion du matériau constituant la protubérance, refroidir, et solidifier la protubérance de soudure fondue. La surface de la protubérance de soudure est, en effet, revêtue par un film en oxyde comme un enrobage dur, de telle sorte que, même si la pointe est pressée fermement contre la protubérance de soudure en chauffant au dessus de la température de fusion du matériau constituant la protubérance, la soudure ne coule pas sur le côté, et il n'y a pas production d'un pont de soudure. Le maintien mécanique est assuré par la brasure. Cependant, à faible pas, il est nécessaire de protéger les connexions du cisaillement mécanique du à la différence de coefficient de dilatation thermique par un enrobage.

Le principal avantage d'un tel procédé de connexion électrique par insertion est de pouvoir se passer du flux, contrairement aux méthodes d'hybridation conventionnelles (brasure de protubérances et thermo-compression) qui font appel à l'utilisation d'une solution d'attaque chimique, le flux, permettant d'éliminer la couche d'oxyde natif en surface de l'alliage. Dans ces méthodes l'étape de rinçage du flux est délicate à réaliser à faible pas. Des résidus de flux font, en effet, obstacle à la propagation de la colle d'enrobage servant à protéger les billes lors des étapes d'amincissement ou lors d'utilisation du dispositif à chaud ou à froid en renforçant le couplage thermomécanique entre la puce et le substrat, ce qui entraîne la présence de bulles qui sont néfastes à un empilement d'un point de vue thermomécanique.

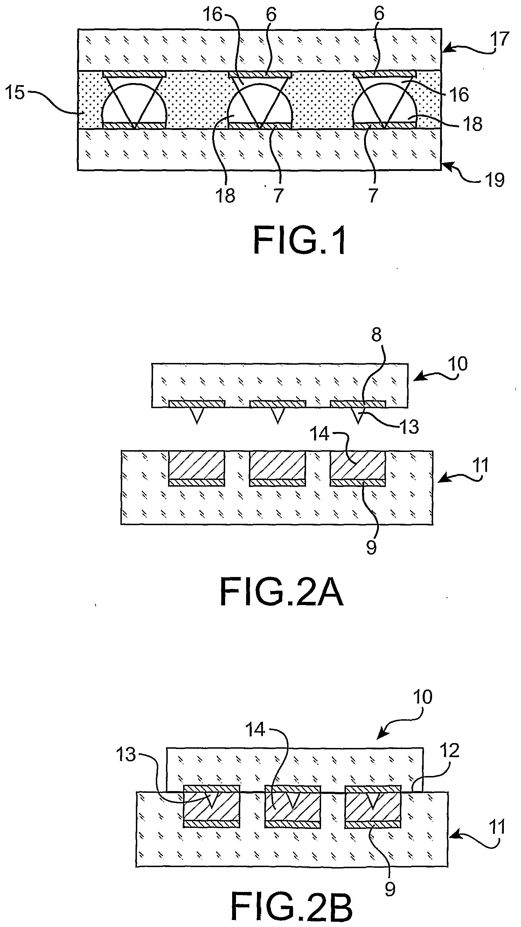

Ainsi dans ce procédé l'art connu, comme illustré schématiquement sur la figure 1, on réalise une connexion entre les plots 6 d'un premier composant 17 et les plots 7 d'un second composant 19, par exemple un substrat, par insertion d'un ensemble de pointes conductrices dures 16 disposé sur une face de ce premier composant 17 dans un ensemble de protubérances conductrices ductiles 18 disposé sur une face du second composant 19, chaque pointe 16 du premier composant 17 correspondant à une protubérance 18 du second composant 19. Le maintien mécanique est assuré par une colle d'enrobage 15.

L'objet de l'invention est de permettre un scellement direct entre composants en éliminant l'étape d'enrobage, difficile à faible pas.

Le document référencé [3] en fin de description décrit un procédé de connexion électrique entre un premier composant comportant, sur une face, un ensemble de premiers plots et un ensemble de colonnes conductrices et un second composant comportant, sur une face, un ensemble de seconds plots et un adhésif conducteur, dans lequel on met en vis-à-vis ces deux faces et on les rapproche de telle façon que les colonnes pénètrent dans l'adhésif conducteur.

### EXPOSÉ DE L'INVENTION

La présente invention est plus particulièrement définie dans les revendications.

La présente invention concerne un procédé de connexion électrique entre un premier composant comportant, sur une face, un ensemble de premiers plots et un ensemble de pointes conductrices dures et un second composant comportant, sur une face, un ensemble de seconds plots et un ensemble de protubérances conductrices ductiles, dans lequel on met en vis-à-vis les deux faces et on les rapproche de telle façon que les pointes puissent pénétrer dans ces protubérances, caractérisé en ce que les protubérances sont enterrées.

Avantageusement le maintien mécanique entre les deux composants est assuré par collage à l'interface entre les composants, entre les protubérances, par exemple par scellement par adhésion moléculaire réalisé à la température ambiante grâce à une passivation plasma ou par une colle.

On réalise ainsi les connexions électriques à un niveau topologique différent de celui du contact mécanique. L'enrobage qui servait à protéger mécaniquement les connexions n'est plus nécessaire.

Dans un mode de réalisation les protubérances sont obtenues par croissance électrolytique ou dépôt au fond de cavités réalisées dans une couche de passivation ou par gravure.

Dans un mode de réalisation les pointes sont obtenues par dépôt métallique, gravure, croissance électrolytique, nanoimpression métallique, ou croissance de nanotubes alignés.

L'invention concerne également un composant comportant, sur une face, un ensemble de plots et un ensemble de protubérances conductrices ductiles apte à être connecté électriquement avec un autre composant muni, sur une face, d'un ensemble de plots et d'un ensemble de pointes conductrices dures, caractérisé en ce que les protubérances sont enterrées.

Chaque protubérance est en matériau conducteur électrique comme par exemple une pâte à brasure ou une colle conductrice.

Chaque pointe peut être en métal, plus généralement en matériau conducteur. Chaque pointe peut aussi être un nanotube ou un nanofil.

En enterrant les protubérances dans un composant (par exemple un substrat ou une puce), on dissocie le niveau de connectique de celui de maintien mécanique. Ce nouveau concept d'hybridation rend compatible la technique d'insertion et de report direct d'un composant sur l'autre, et permet ainsi d'éliminer l'étape d'enrobage, difficile d'un point de vue technologique à faible pas. Elle offre l'avantage d'être à température ambiante, « sans-flux » car la pointe vient percer la croûte d'oxyde natif en surface d'une protubérance, et nécessite une faible pression mécanique.

### BRÈVE DESCRIPTION DES DESSINS

La figure 1 illustre un procédé de l'art connu.
Les figures 2A et 2B illustrent la réalisation d'une connexion par insertion d'un ensemble de pointes dans des protubérances enterrées selon le procédé de l'invention.
Les figures 3A à 7C illustrent plusieurs modes de réalisation du procédé de l'invention.

### EXPOSÉ DÉTAILLÉ DE MODES DE RÉALISATION PARTICULIERS

Le procédé de l'invention est un procédé de connexion électrique de plots utilisant la technique « flip chip » sans flux.

Dans le procédé de l'invention on réalise cette connexion entre les plots 8 d'un premier composant 10 et les plots 9 d'un second composant 11, par exemple un substrat, par insertion d'un ensemble de pointes conductrices dures 13 disposé sur une face de ce premier composant 10 dans un ensemble de protubérances conductrices ductiles enterrées 14 disposées sur une face du second composant, comme illustré sur les figures 2A et 2B.

Les connexions électriques sont réalisées par insertion de pointes conductrices dures dans des protubérances conductrices ductiles enterrées. On peut ainsi reporter directement un composant sur l'autre, par exemple une puce sur un substrat. Le maintien mécanique est assuré par un collage à l'interface entre les protubérances. Il s'agit par exemple d'un collage traditionnel ou d'un scellement par adhésion moléculaire, réalisé à température ambiante grâce à une activation plasma. Comme la partie dans laquelle on insère la pointe est enterrée, on réalise un scellement direct des deux composants et on élimine l'étape d'enrobage de l'art connu.

De plus, le maintien mécanique se faisant non plus par les connexions mais par la surface entre les composants, il n'est plus nécessaire de chauffer. L'hybridation peut se faire à température ambiante. En effet, si les pointes sont suffisamment aiguisées et le matériau des protubérances suffisamment ductile, l'insertion peut se faire uniquement par application d'une pression mécanique.

Une telle insertion peut être réalisée en jouant sur les modules d'Young des matériaux respectifs constituant les pointes 13 et les protubérances 14, et/ou sur la forme de pointes 13. En effet, plus le rapport des modules d'Young entre les deux matériaux est élevé, plus l'insertion est facile. On peut donc choisir n'importe quel couple de matériaux conducteurs : par exemple une pointe en métal ou en un matériau quelconque recouvert d'une couche métallique et une protubérance en pâte à brasure (In, SnPb, AuSn...). De même, plus la pointe a une forme pointue, moins la pression à exercer est importante. Les pointes 13 doivent être suffisamment dures et fines (par exemple angle au sommet inférieur à 30°, rapport supérieur à 10 entre les 2 modules d'Young) pour pouvoir percer la croûte d'oxyde et s'enfoncer dans les protubérances 14 avec une pression mécanique minimale.

Le scellement par adhésion moléculaire avec activation de surface SAB (« Surface Activated Bonding »), envisagé ci-dessus pour le collage entre les deux composants, présente les avantages suivants.

Le report direct d'un composant sur l'autre par un scellement par adhésion moléculaire à température ambiante est possible. Il n'y a donc pas de décalage des plots en vis-à-vis lors de l'hybridation. Jusqu'alors, le scellement par adhésion moléculaire n'était pas envisageable dans la technologie « flip chip » du fait du traitement thermique haute température (1000°C) qu'il nécessitait pour consolider les liaisons. Grâce à l'activation des surfaces par plasma SAB (« Surface Activated Bonding »), on est aujourd'hui capable de réaliser des scellements à température ambiante.

Le scellement par adhésion moléculaire « classique » (c'est-à-dire sans activation de surface) consiste à mettre en contact deux matériaux à température ambiante après traitement physico-chimique de leur surface, puis à réaliser un traitement thermique haute température afin de consolider la structure cristalline par création de liaisons atomiques.

L'activation plasma permet d'effectuer un nettoyage physico-chimique des surfaces à l'échelle atomique par bombardement de particules excitées. Des liaisons se cassent en surface et des liaisons pendantes sont créées. Les surfaces sont alors suffisamment réactives pour que la qualité de scellement obtenue à température ambiante soit mécaniquement acceptable et qu'une consolidation par traitement thermique ne soit pas indispensable. Ainsi l'hybridation peut être réalisée à température ambiante. On évite les problèmes de décalage de plots lors des hybridations chaud (dus à la différence de coefficient de dilatation thermique de la puce et du substrat).

On peut également réaliser le report par toute autre méthode de scellement : collage polymère, scellement eutectique, brasure...

### Réalisation des protubérances enterrées

Les protubérances ductiles enterrées peuvent être réalisées par exemple par croissance électrolytique au fond des cavités réalisées dans une couche de passivation. La couche de passivation peut être du Si02 et les caissons peuvent être en indium ou aluminium.

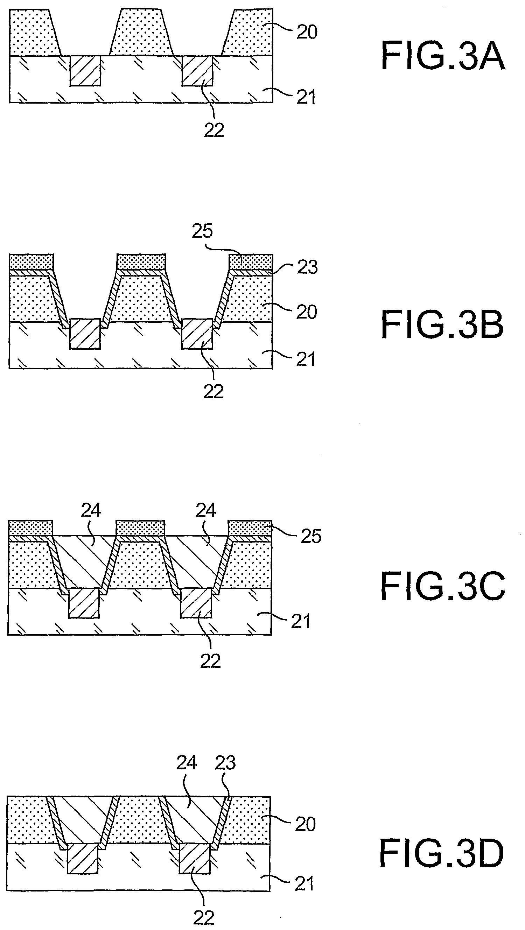

On peut avoir, ainsi, les étapes suivantes :
- une étape de dépôt d'une couche de passivation 20 (par exemple Si02) sur un substrat 21 muni de plots 22 puis une étape de gravure chimique (figure 3A),
- une étape de dépôt d'un fond continu en Ti 23 (figure 3B),
- une étape de dépôt d'un masque en résine 25,
- une étape de croissance électrolytique par exemple d'indium 24 (figure 3C) ou de tout matériau conducteur ductile,
- une étape de gravure chimique sélective du fond continu (figure 3D) et de la résine.

### Réalisation des pointes

L'ensemble de pointes peut être obtenu de plusieurs manières, par exemple par dépôt par métallique, gravure, croissance électrolytique, procédé électrodéposition (« electroless »), nanoimpresion métallique ou croissance de nanotubes de carbone alignés...

### 1) Dépôt métallique

Une première technique consiste à réaliser un dépôt de métal par pulvérisation au-dessus de cavités de résine. Au fur et à mesure du dépôt l'ouverture s'obstrue et la quantité de métal déposé en fond de cavité diminue. Ainsi la forme obtenue en fond de cavité devient conique.

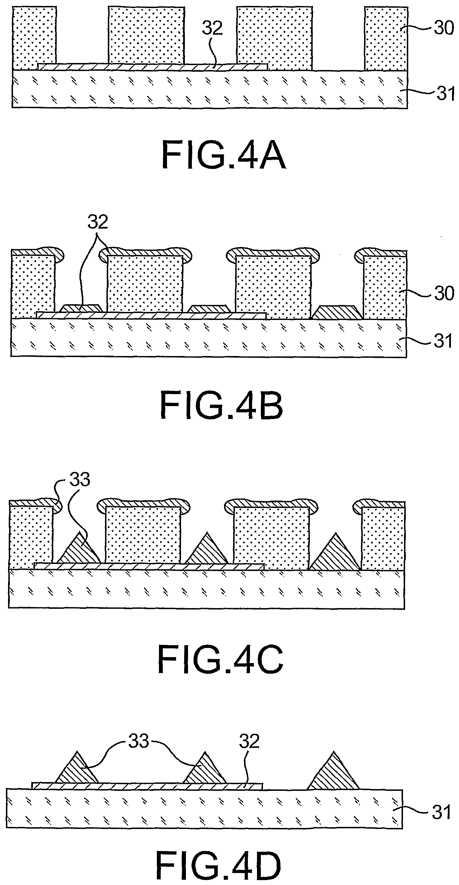

On a ainsi les étapes suivantes :
- une étape de dépôt d'un masque de résine 30 par « lift-off » sur un substrat 31 muni de plots 32(figure 4A),
- une étape de dépôt d'un métal 33 (figures 4B et 4C),
- une étape de retrait de la résine (figure 4D).

Une deuxième technique consiste à réaliser l'étape de dépôt sur toute la plaque, de déposer un masque en résine puis à graver le métal par gravure chimique.

### 2) Croissance électrolytique

On peut également réaliser une croissance électrolytique d'un métal au fond d'une cavité de résine dont les flancs sont obliques. Cette oblicité peut-être obtenue par exemple grâce à un double résinage. On dépose alors deux types de résines qui n'ont pas la même sensibilité à l'insolation. Une fois insolées, elles ne se dissolvent pas de la même façon.

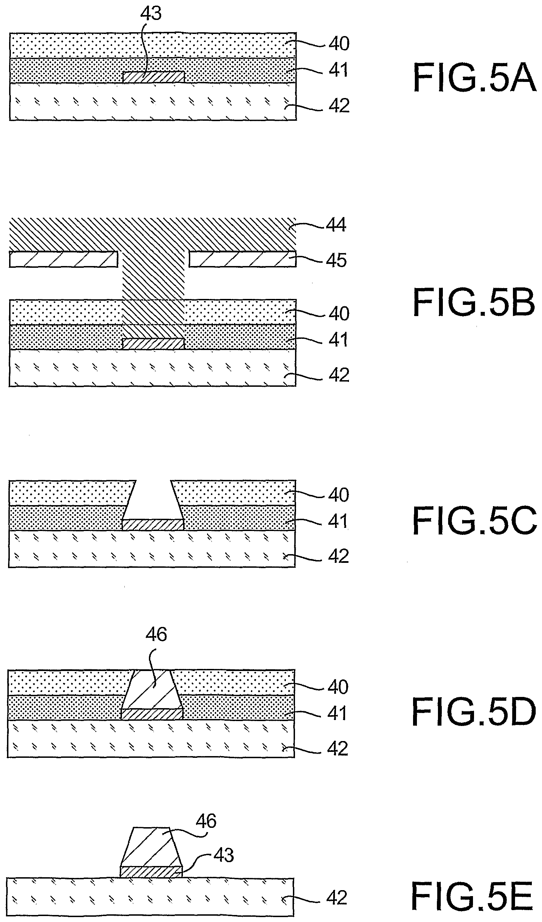

On a ainsi les étapes suivantes :
- une étape de double résinage par dépôt de deux résines 40 et 41 sur un substrat 42 muni de plots 43(figure 5A),
- une étape d'insolation au rayonnement ultrat-violet 44 sous masque 45 (figure 5B),
- une étape de dilution des résines insolées (figure 5C),
- une étape de dépôt électrolytique du matériau 46 constituant les pointes (figure 5D),
- une étape de retrait des deux résines 40 et 41 (figure 5E).

### 3) Nanoimpression métallique

A l'origine, la technique de nanoimpression est utilisée pour mouler des polymères, mais il est également envisageable de mouler des alliages à condition de les chauffer aux alentours de la température de fusion. Il faut choisir des alliages à bas point de fusion.

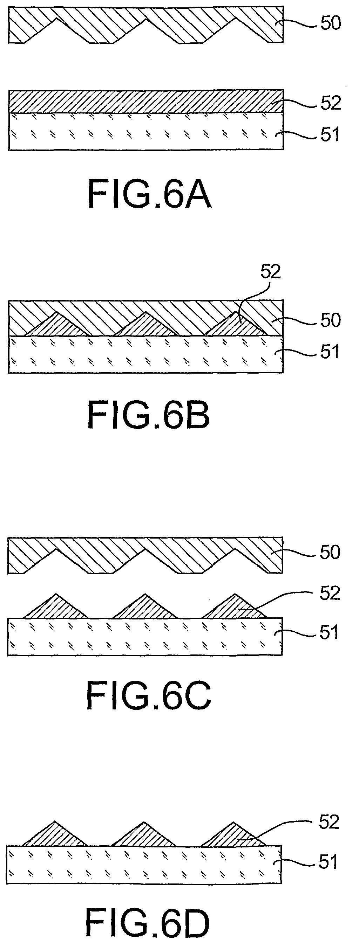

On a ainsi les étapes suivantes :
- une étape d'emboutissage d'un moule 50 sur un substrat 51 sur lequel est déposée classiquement une couche d'alliage 52, (figures 6A et 6B),
- une étape de retrait du moule (figures 6C et 6D).

Les motifs du moule peuvent être réalisés de plusieurs manières : on peut utiliser un moule, en silicium par exemple, et réaliser les trous pyramidaux par attaque chimique anisotrope (KOH) suivant des plans cristallins. On peut également réaliser le moule par emboutissage à chaud. Le matériau doit être suffisamment résistant thermiquement et mécaniquement pour ne pas cliver sous l'application d'une force.

### 4) Croissance de pointes en nanotubes de carbones.

On peut faire croître des nanotubes sous champ électrique afin de les orienter. Cette technique est décrite dans le document référencé [2]. Ce document envisage, en effet, la croissance directe de réseaux de nanotubes de carbone alignés verticalement sur des substrats en plastique flexible en utilisant un dépôt de vapeur chimique.

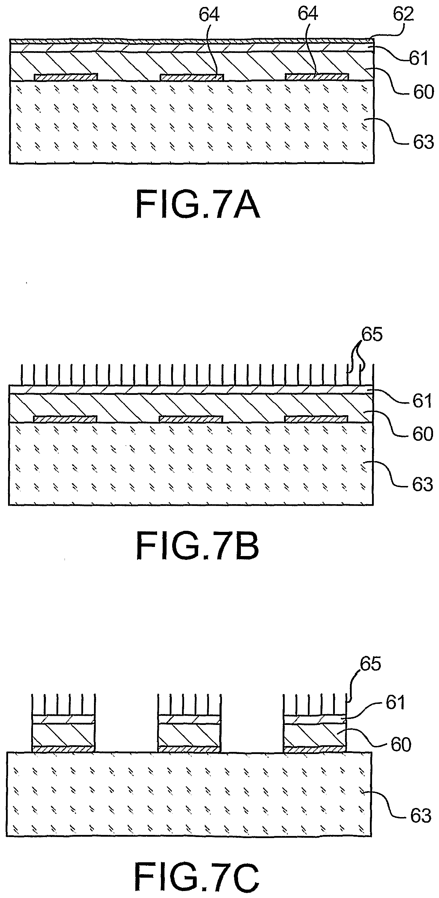

On a alors les étapes suivantes :
- une étape de dépôt de TiN 60, de dépôt de Ni 61 et de dépôt de catalyseur 62 sur un substrat 63 muni de plots 64 (figure 7A),
- une étape de mise en goutte du catalyseur et de croissance des nanotubes 65 à 450°C (figure 7B).

De façon avantageuse, ces nanotubes peuvent croître localement grâce à un procédé de masquage lors du dépôt des différentes couches nécessaires à leur élaboration (figure 7C).

### REFERENCES

[1] US 6,179 198
[2] Article intitulé « Patterned selective growth of carbon nanotubes and large field émission from vertically well-aligned carbon nanotube field emitter arrays » de Jung-Inn Sohn, Seonghoon-Lee ; Yoon-Ho-Song ; Sung-Yool-Choi; Kyoung-Ik-Cho; Kee-Soo-Nam (Applied physics Letters, 12/2/2001, 78(7), pages 901-903).
[3] US 2003/0234277

## Revendications

1. Procédé de connexion électrique entre un ensemble de premiers plots (8) situés sur une face d'un premier composant (10) et un ensemble de seconds plots (9) situés sur une face d'un second composant (11),
**caractérisé en ce que** ledit procédé comprend les étapes suivantes :
- réalisation d'un ensemble de pointes conductrices dures (13) sur l'ensemble de premiers plots (8) situés sur le premier composant (10),
- réalisation d'un ensemble de protubérances conductrices ductiles enterrées (14) sur l'ensemble de seconds plots (9) situés sur le second composant (11),
- mise en vis-à-vis des pointes conductrices dures (13) et des protubérances conductrices ductiles enterrées (14), situées respectivement sur ces deux faces,
- report direct du premier composant (10) sur le second composant (11) de telle sorte que les pointes conductrices dures (3) pénètrent dans les protubérances conductrices ductiles enterrées (14),
et **en ce que** le maintien mécanique entre les deux composants (10, 11) est assuré par un collage à l'interface de ces deux composants, entre les protubérances (14).

2. Procédé selon la revendication 1, dans lequel le collage est un scellement par adhésion moléculaire réalisé à température ambiante grâce à une activation plasma.

3. Procédé selon la revendication 1, dans lequel les protubérances enterrées (24) sont obtenues par croissance électrolytique au fond de cavités réalisées dans une couche de passivation (20).

4. Procédé selon la revendication 1, dans lequel on a les étapes suivantes :
- une étape de dépôt d'une couche de passivation (20) sur un substrat (21) muni de plots (22) puis une étape de gravure chimique,
- une étape de dépôt d'un fond continu en matériau conducteur (23),
- une étape de masquage,
- une étape de croissance électrolytique d'un matériau ductile (24) pour définir les protubérances,
- une étape de gravure chimique sélective pour retirer le masque et le fond continu.

5. Procédé selon la revendication 1, dans lequel les pointes sont obtenues par dépôt métallique, gravure, croissance électrolytique, nanoimpression métallique, ou croissance de nanotubes alignés.

6. Dispositif consistant en la connexion électrique entre un premier composant (10) et un second composant (11),
**caractérisé en ce qu'**un ensemble de premiers plots (8) est situé sur une face du premier composant (10), et un ensemble de pointes conductrices dures (13) est situé sur cet ensemble de premiers plots (8),
**en ce qu'**un ensemble de seconds plots (9) est situé sur une face du second composant (11) et un ensemble de protubérances conductrices ductiles enterrées (14) est situé sur l'ensemble de seconds plots (9),
**en ce que** les pointes conductrices dures (13) ont pénétré dans les protubérances conductrices ductiles enterrées (14) de sorte qu'une connexion électrique entre les premiers plots (8) et les seconds plots (9) situés respectivement sur ces deux faces est établie, entre le premier composant (10) et le second composant (11),
et **en ce que** le maintien mécanique entre les deux composants est assuré par collage à l'interface des deux composants, entre les protubérances (14).

7. Dispositif selon la revendication 6, dans lequel chaque pointe est constituée toute ou en partie par un matériau conducteur électrique.

8. Dispositif selon la revendication 6, dans lequel chaque pointe est constituée d'un nanotube ou d'un nanofil.

9. Dispositif selon la revendication 6, dans lequel chaque protubérance est constituée d'au moins un matériau conducteur électrique.

10. Composant selon la revendication 9, dans lequel le matériau de la protubérance est choisi parmi une pâte à brasure ou une colle conductrice.

## Patentansprüche

1. Verfahren zur elektrischen Verbindung zwischen einer Gesamtheit von ersten Kontaktpunkten (8), die auf einer Fläche einer ersten Komponente (10) angeordnet sind, und einer Gesamtheit von zweiten Kontaktpunkten (9), die auf einer Fläche einer zweiten Komponente (11) angeordnet sind,
**dadurch gekennzeichnet, dass** das Verfahren die folgenden Schritte umfasst:
- Realisieren einer Gesamtheit von leitfähigen harten Spitzen (13) auf der Gesamtheit von ersten Kontaktpunkten (8), die auf der ersten Komponente (10) angeordnet sind,
- Realisieren einer Gesamtheit von leitfähigen duktilen vergrabenen Vorsprüngen (14) auf der Gesamtheit von zweiten Kontaktpunkten (9), die auf der zweiten Komponente (11) angeordnet sind,
- Anordnen der leitfähigen harten Spitzen (13) und der leitfähigen duktilen vergrabenen Vorsprüngen (14), die auf diesen zwei jeweiligen Flächen angeordnet sind, einander gegenüberliegend,
- direktes Anbringen der ersten Komponente (10) an der zweiten Komponente (11) derart, dass die leitfähigen harten Spitzen (3) in die leitfähigen duktilen vergrabenen Vorsprünge (14) eindringen,
und dass der mechanische Halt zwischen den zwei Komponenten (10, 11) durch eine Verklebung an der Grenzfläche dieser zwei Komponenten zwischen den Vorsprüngen (14) sichergestellt wird.

2. Verfahren nach Anspruch 1, wobei die Verklebung eine Versiegelung durch molekulare Adhäsion ist, die bei Umgebungstemperatur mittels einer Plasmaaktivierung realisiert wird.

3. Verfahren nach Anspruch 1, wobei die vergrabenen Vorsprünge (24) durch elektrolytisches Wachstum am Boden von Hohlräumen erhalten werden, die in einer Passivierungsschicht (20) realisiert sind.

4. Verfahren nach Anspruch 1, umfassend die folgenden Schritte:
- einen Schritt des Aufbringens einer Passivierungsschicht (20) auf einem Substrat (21), das mit Kontaktpunkten (22) ausgestattet ist, und anschließend einen Schritt des chemischen Ätzens,
- einen Schritt des Aufbringens eines kontinuierlichen Bodens aus leitfähigem Material (23),
- einen Schritt des Maskierens,
- einen Schritt des elektrolytischen Wachstums eines duktilen Materials (24), um die Vorsprünge zu definieren,
- einen Schritt des selektiven chemischen Ätzens, um die Maske und den kontinuierlichen Boden zu entfernen.

5. Verfahren nach Anspruch 1, wobei die Spitzen erhalten sind durch metallische Aufbringung, Ätzen, elektrolytisches Wachstum, metallischen Nanodruck, oder Wachstum von ausgerichteten Nanoröhrchen.

6. Vorrichtung, umfassend eine elektrische Verbindung zwischen einer ersten Komponente (10) und einer zweiten Komponente (11),
**dadurch gekennzeichnet, dass** eine Gesamtheit von ersten Kontaktpunkten (8) auf einer Fläche der ersten Komponente (10) angeordnet ist, und eine Gesamtheit von leitfähigen harten Spitzen (13) auf dieser Gesamtheit von ersten Kontaktpunkten (8) angeordnet ist,
dass eine Gesamtheit von zweiten Kontaktpunkten (9) auf einer Fläche der zweiten Komponente (11) angeordnet ist, und eine Gesamtheit von leitfähigen duktilen vergrabenen Vorsprüngen (14) auf der Gesamtheit von zweiten Kontaktpunkten (9) angeordnet ist,
dass die leitfähigen harten Spitzen (13) in die leitfähigen duktilen vergrabenen Vorsprünge (14) derart eingedrungen sind, dass eine elektrische Verbindung zwischen den ersten Kontaktpunkten (8) und den zweiten Kontaktpunkten (9), die auf diesen zwei jeweiligen Flächen angeordnet sind, zwischen der ersten Komponente (10) und der zweiten Komponente (11) hergestellt ist,
und dass der mechanische Halt zwischen den zwei Komponenten durch eine Verklebung an der Grenzfläche der zwei Komponenten zwischen den Vorsprüngen (14) sichergestellt ist.

7. Vorrichtung nach Anspruch 6, wobei jede Spitze ganz oder teilweise durch ein elektrisch leitendes Material gebildet ist.

8. Vorrichtung nach Anspruch 6, wobei jede Spitze durch ein Nanoröhrchen oder einen Nanodraht gebildet ist.

9. Vorrichtung nach Anspruch 6, wobei jeder Vorsprung durch wenigstens ein elektrisch leitendes Material gebildet ist.

10. Komponente nach Anspruch 9, wobei das Material des Vorsprungs aus einer Lötpaste oder einem leitfähigen Kleber ausgewählt ist.

## Claims

1. Method of electrical connection between a series of first pads (8) located on a face of a first component (10) and a series of seconds pads (9) located on a face of a second component (11)
**Characterized in that** said method comprises the following process steps:
- producing a series of hard conductive points (13) on the series of first pads (8) located on the first component (10),
- producing a series of buried ductile conductive bumps (14) on the series of second pads (9) located on the second component (11),
- facing the hard conductive points (13) and the buried ductile conductive bumps (14), located, respectively, on these two faces,
- direct transfer of the first component (10) on the second component (11) so that the hard conductive points (13) penetrate into the buried ductile conductive bumps (14),
and **in that** the mechanical holding between the two components (10, 11) is assured by a bonding at the interface of these two components, between the bumps (14).

2. Method according to claim 1, in which the bonding is a sealing by molecular adhesion carried out at ambient temperature by means of a plasma activation.

3. Method according to claim 1, in which the buried bumps (24) are obtained by electrolytic growth at the base of cavities formed in a passivation layer (20).

4. Method according to claim 1, in which one has the following steps:
- a step of deposition of a passivation layer (20) on a substrate (21) equipped with pads (22) then a step of chemical etching,
- a step of deposition of a continuous base in conductor material (23),
- a step of masking,
- a step of electrolytic growth of a ductile material (24) for defining the bumps,
- a step of selective chemical etching to remove the mask and the continuous base.

5. Method according to claim 1, in which the points are obtained by metallic deposition, etching, electrolytic growth, metallic nanoprinting, or growth of aligned nanotubes.

6. Device consisting in the electrical connection between a first component (10) and a second component (11),
**characterized in that** a series of first pads (8) is located on a face of the first component (10), and a series of hard conductive points (13) is located on the series of first pads (8),
**in that** a series of seconds pads (9) is located on a face of the second component (11), and a series of buried ductile conductive bumps (14) is located on the series of second pads (9),
**in that** the hard conductive points (13) have penetrated into the buried ductile conductive bumps (14) so that an electrical connection between the first pads (8) and the second pads (9), located of these two faces, is established, between the first component (10) and the second component (11),
and **in that** the mechanical holding between the two components (10, 11) is assured by a bonding at the interface of these two components, between the bumps (14).

7. Device according to claim 6, in which each point is constituted all or in part by an electric conductor material.

8. Device according to claim 6, in which each point is constituted of a nanotube or a nanowire.

9. Device according to claim 6, in which each bump is constituted of at least one electric conductor material.

10. Device according to claim 9, in which the material of the bump is chosen among a soldering paste or conductive adhesive.
